# EUROPEAN PATENT APPLICATION

(11) **EP 2 273 511 A1**
(43) Date of publication of application: **12.01.2011**
(21) Application number: 10168768.9
(22) Date of filing: 07.07.2010
(51) Int. Cl.: H01B 1/04, B32B 7/12

(54) **Conductive plate and method for making the same**

(30) Priority: 08.07.2009 CN 200910304130
(71) Applicant: Chimei InnoLux Corporation, Chu-Nan 350, Taipei (TW)
(72) Inventor: Chang, Chih-Chieh, 350, Chu-Nan Taipei (TW); Tsai, Chung-Wei, 350, Chu-Nan Taipei (TW); Wu, Jeah-Sheng, 350, Chu-Nan Taipei (TW); Cheng, Jia-Shyong, 350, Chu-Nan Taipei (TW)
(74) Representative: Gray, John James

(57) **Abstract**

A method for making a conductive plate comprises providing a conductive film (300) exhibiting electric anisotropy, and bonding the conductive film to a substrate through an adhesive (200). A conductive plate comprises a substrate and a composite attached to said substrate. The composite comprises a conductive film (300) exhibiting electric anisotropy and an adhesive (200) penetrating into said conductive film.

## Description

### BACKGROUND

### 1. Technical Field

The present disclosure relates to a conductive plate and a method for making the same, more particularly to a conductive plate comprising a conducive film exhibiting electric anisotropy and a method for making the same.

### 2. Description of Related Art

Transparent conductive films (TCFs) having transmittance and conductivity are widely used in flat panel displays (FPD), touch panels, electromagnetic wave-proof devices, solar cells, for example.

TCFs are normally made from indium tin oxide (ITO), tin oxide (SnO2), zinc oxide (ZnO), for example. Among them, ITO is best qualified for commercial use in manufacturing electric-optical devices by virtue of its high transmittance and high conductivity.

ITO conductive film is usually formed on a substrate by sputtering an ITO target through vacuum sputtering techniques. Conventionally, the substrate used for deposition of the ITO conductive film is limited to glass, poly(ethylene terephthalate) (PET), for example.

The glass substrate or PET substrate with an ITO conductive film may be also called "conductive plate". When the conductive plate is bent, the ITO conductive film of the conductive plate is likely to be deformed and damaged. In addition, the manufacturing process of ITO is complicated, indium is harmful to the environment, and shortage of indium raw material will be getting worse in the future which can result in an increase in manufacturing costs of the conductive plate. Hence, there is a need in the art to find a conductive material that can overcome the aforesaid drawbacks encountered in the use of ITO.

### SUMMARY

According to one aspect of the present disclosure, there is provided a method for making a conductive plate. The method comprises: (a) providing a conductive film exhibiting electric anisotropy; and (b) bonding the conductive film to a substrate through an adhesive.

According to another aspect of the present disclosure, there is also provided a conductive plate. The conductive plate comprises a substrate and a composite attached to the substrate. The composite comprises a conductive film exhibiting electric anisotropy, and an adhesive penetrating into the conductive film.

### BRIEF DESCRIPTION OF THE DRAWINGS

The components in the drawings are not necessarily drawn to scale, the emphasis instead being placed upon clearly illustrating the principles of at least one embodiment. In the drawings, like reference numerals designate corresponding parts throughout the various views.

FIG. 1 is a sectional side view illustrating an embodiment of the conductive plate according to the present disclosure.

FIG. 2 is a perspective view illustrating an embodiment of the method for making the conductive film of the conductive plate according to the present disclosure.

FIG. 3 is a schematic top view with an SEM photo illustrating an embodiment of the conductive film of the conductive plate according to the present disclosure.

FIG. 4 is a schematic side view with an SEM photo illustrating an embodiment of the conductive film of the conductive plate according to the present disclosure.

### DETAILED DESCRIPTION

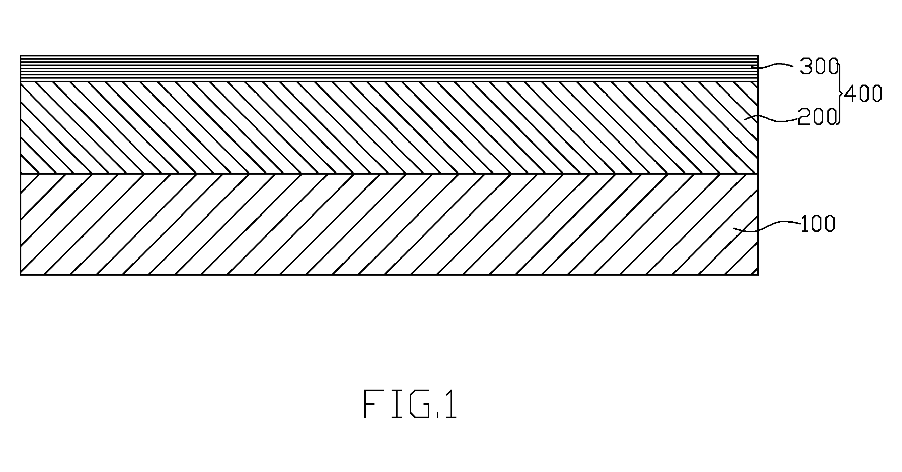

Referring to FIG. 1, the embodiment of a conductive plate according to the present disclosure includes a substrate 100, and a composite 400. The composite 400 is attached to the substrate 100. The composite 400 includes a conductive film 300, and an adhesive 200. The conductive film 300 exhibits electric anisotropy, and the adhesive 200 penetrates into the conductive film 300.

The substrate 100 may be a transparent substrate or an opaque substrate. Examples of the transparent substrate include, but are not limited to, a glass substrate, and a polymer substrate. The polymer substrate may be, but is not limited to, made from a material selected from the group consisting of polymethylmethacrylate, polyethylene terephthalate and polycarbonate.

The opaque substrate may be made from a material selected from the group consisting of a metal substrate, a semiconductor substrate, a printed circuit board, and a plastic substrate, for example The plastic substrate may be a colored plastic substrate or coated with a colored coating.

The type of the adhesive 200 may be determined according to the curing method of interest. For example, the adhesive 200 is selected from the group consisting of a light curable adhesive, a heat curable adhesive, and a light-heat curable adhesive. The light curable adhesive described herein represents an adhesive that is cured by irradiation with a light having a specified range of the wavelength, such as an ultraviolet glue. The heat curable adhesive described herein represents an adhesive that is cured over an elevated temperature. The light-heat curable adhesive described herein represents an adhesive that is cured by irradiation with the light having a specified range of the wavelength over an elevated temperature. Additionally, the adhesive 200 may be also a conductive adhesive, for example, a conductive polymer adhesive.

The conductive film 300 exhibiting electric anisotropy is preferably made from a nanomaterial that has a cluster of interconnected nanounits extending along a predetermined direction. "Electric anisotropy" used herein is also called "conductive anisotropy" or "resistivity anisotropy", and is a property having different conductivities or resistivities in different directions.

An embodiment of a method for making a conductive plate according to the present disclosure includes the steps of: (a) providing a conductive film 300 exhibiting electric anisotropy; and (b) bonding the conductive film 300 to a substrate 100 through an adhesive 200.

The conductive film 300 can be made from a nanomaterial. For instance" the nanomaterial has a cluster of interconnected nanounits extending along a predetermined direction. The nanounits can be carbon nanotubes, carbon nanotube bundles, or nanoparticles.

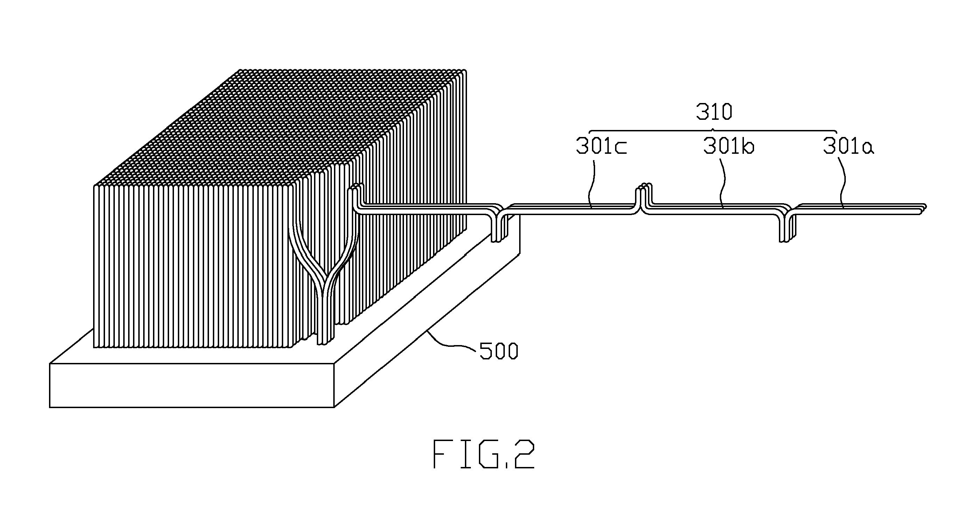

Referring to FIG. 2, the conductive film 300 provided in step (a) is formed by the sub-steps of: (a1) forming a cluster of interconnected nanounits 301 on a substrate 500; and (a2) stretching the nanounits 301 along a predetermined direction to remove the nanounits 301 from the substrate 500 (FIG. 2 shows that only a portion of the nanounits 301 is removed from the substrate 500 for the sake of clarity), so as to form a conductive film 300 having strings of interconnected nanounits 310.

In more detail, in sub-step (a2), for instance, the nanounits 301 include the nanounit 301a, the nanounit 301b, and the nanounit 301c. When the nanounit 301a is stretched along a predetermined direction to remove the nanounits 301a from the substrate 500, the nanounit 301b which is adjacent to the nanounit 301a is also peeled from the substrate 500 by the nanounit 301a through a Van der Waals' interaction therebetween. In a similar way, the nanounit 301c which is adjacent to the nanounit 301b is also peeled from the substrate 500 by the nanounit 301b through a Van der Waals' interaction therebetween when the nanounit 301b is stretched. As a result of to the Van der Waals' interaction, the nanounit 301a, the nanounit 301b, and the nanounit 301c are respective series connect to form a string of interconnected nanounits 310. As a consequence, the nanounits 301 on the substrate 500 can be removed substantially in a line by line manner so as to form strings of interconnected nanounits 310, that consists the conductive film 300 exhibiting electric anisotropy.

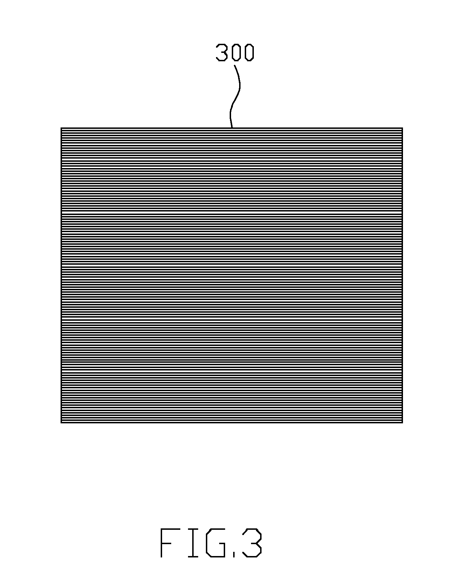

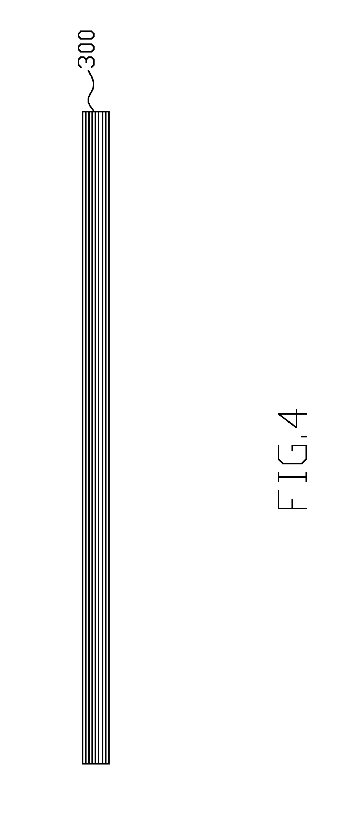

Referring to FIGS. 3 and 4, the structure of the conductive film 300 is shown to include a plurality of the strings of interconnected nanounits 310. The interconnected nanounits 301 of each string substantially extend in the predetermined direction denoted by "X". The strings of interconnected nanounits 310 are interconnected. The conductive film 300 exhibits a smaller resistivity in "X" direction and a higher resistivity in a transverse direction relative to the "X" direction, and hence the conductive film 300 exhibits electric anisotropy.

Each of the nanounits 301 may be a nanounit having an anisotropic shape, i.e., the length of the nanounit is different from the width of the nanounit. The nanounits can be nanotubes, and/or nano particles, for example.

If thinning of the conductive film 300 is required to adjust the property of the conductive film 300, a thermal treatment of the conductive film 300 can be performed before attaching the conductive film 300 to the substrate 100. The thermal treatment may be conducted by a technique that includes, but is not limited to, plasma techniques, infrared rays techniques, ultraviolet rays irradiation techniques, heating techniques, laser heating techniques, for example. For example, the thermal treatment is conducted by laser heating techniques.

In step (b), as shown in FIG. 1, the conductive film 300 is bonded to the substrate 100 through the adhesive 200. For instance, the bonding of the conductive film 300 in step (b) is conducted by the sub-steps of: (b1) coating the adhesive 200 on the substrate 100; (b2) disposing the conductive film 300 on the adhesive 200; and (b3) curing the adhesive 200 so as to form the conductive plate.

For example, in sub-step (b1), the coating may be conducted by one of printing, spin coating, liquid drop coating, for example.

In sub-step (b3), the adhesive 200 penetrates into the conductive film and cooperates with the conductive film 300 to form a composite. The type of curing may be varied in accordance with the type of the adhesive to be used in the method. For example, when the adhesive 200 is a light curable adhesive, the adhesive 200 is cured by irradiation with a light having a specified range of the wavelength; or when the adhesive 200 is a heat curable adhesive, the adhesive 200 is cured over an elevated temperature; or when the adhesive 200 is a light-heat curable adhesive, the adhesive 200 is cured by irradiation with the light having a specified range of the wavelength over an elevated temperature.

For example, the thickness of the composite 400 is less than 15 µm, and the thickness of the conductive film 300 of the composite 400 is less than 300 nm.

In sum, the conductive film 300 thus formed is flexible and the manufacturing process of the same is simple.

It is to be understood that even though numerous characteristics and advantages of the present embodiments have been set forth in the foregoing description, together with details of the structures and functions of the embodiments, the disclosure is illustrative only; and that changes may be made in detail, especially in matters of shape, size, and arrangement of parts, within the principles of the embodiments, to the full extent indicated by the broad general meaning of the terms in which the appended claims are expressed.

## Claims

1. A method for making a conductive plate, comprising:
(a) providing a conductive film exhibiting electric anisotropy; and
(b) bonding the conductive film to a substrate through an adhesive.

2. The method of claim 1, wherein the conductive film is formed by stretching a nanomaterial along a predetermined direction so as to exhibit electric anisotropy.

3. The method of claim 1 or 2, wherein the conductive film is subjected to a thermal treatment prior to bonding to the substrate.

4. The method of claim 3, wherein the thermal treatment is conducted by laser heating techniques.

5. The method of any preceding claim, wherein the conductive film is made from a nanomaterial.

6. The method of any preceding claim, wherein the adhesive is selected from the group consisting of a light curable adhesive, a heat curable adhesive, and a light-heat curable adhesive.

7. The method of any preceding claim, wherein the adhesive is conductive.

8. The method of any preceding claim, wherein the substrate is made from a material selected from the group consisting of polymethyl methacrylate, polyethylene terephthalate, and polycarbonate.

9. The method of any preceding claim, wherein the substrate is a glass substrate.

10. The method of any preceding claim, further comprising curing the adhesive after step (b).

11. A conductive plate, comprising:
a substrate; and
a composite attached to said substrate, comprising:
a conductive film exhibiting electric anisotropy; and
an adhesive penetrating into said conductive film.

12. The conductive plate of claim 11, wherein the thickness of said composite is less than 15 µm.

13. The conductive plate of claim 11 or 12, wherein the thickness of said conductive film is less than 300 nm.

14. The conductive plate of claim 11, 12 or 13, wherein said conductive film is made from a nanomaterial.

15. The conductive plate of claim 14, wherein said nanomaterial has a cluster of interconnected nanounits extending along a predetermined direction.

16. The conductive plate of claim 15, wherein said nanounits are carbon nanotubes, carbon nanotube bundles, or nanoparticles.

17. The conductive plate of claim 14, 15 or 16, wherein the thickness of said conductive film of said composite is less than 300 nm.

18. The conductive plate of any of claims 11 to 17, wherein said adhesive is selected from the group consisting of a light curable adhesive, a heat curable adhesive, and a light-heat curable adhesive.

19. The conductive plate of any of claims 11 to 18, wherein said adhesive is conductive.

20. The conductive plate of any of claims 11 to 19, wherein said substrate is made from a material selected from the group consisting of polymethyl methacrylate, polyethylene terephthalate, and polycarbonate.
